(19) Europäisches Patentamt
European Patent Office
Office européen des brevets

(11) Numéro de publication : **0 297 935 B1**

(12) **FASCICULE DE BREVET EUROPEEN**

(45) Date de publication du fascicule du brevet :
**15.01.92 Bulletin 92/03**

(51) Int. Cl.⁵ : **G01R 33/56**

(21) Numéro de dépôt : **88401294.9**

(22) Date de dépôt : **27.05.88**

(54) Procédé de prise en compte, dans une image, des mouvements d'un objet.

(30) Priorité : **19.06.87 FR 8708658**

(43) Date de publication de la demande :
**04.01.89 Bulletin 89/01**

(45) Mention de la délivrance du brevet :
**15.01.92 Bulletin 92/03**

(84) Etats contractants désignés :
**DE ES GB IT NL SE**

(56) Documents cités :
**EP-A- 0 184 249**
**EP-A- 0 217 196**
**US-A- 4 567 893**

(73) Titulaire : **GENERAL ELECTRIC CGR S.A.**
**13, Square Max-Hymans**
**F-75015 Paris (FR)**

(72) Inventeur : **Le Roux, Patrick CABINET**
**BALLOT-SCHMIT**
**84, Avenue Kléber**
**F-75116 Paris (FR)**

(74) Mandataire : **Schmit, Christian Norbert Marie**
**et al**
**Cabinet Ballot-Schmit 7, rue Le Sueur**
**F-75116 Paris (FR)**

## Description

La présente invention a pour objet un procédé de prise en compte, dans une image, des mouvements d'un objet. Elle trouve plus particulièrement son application dans le domaine médical où on cherche à représenter les mouvements du coeur, des poumons ou l'écoulement du sang, ou au contraire à éliminer dans l'image les perturbations résultant d'artéfacts dits de bougé. La description de l'invention va être faite dans le cadre d'une application d'imagerie par résonance magnétique nucléaire (RNM) sans pour autant être spécifiquement restreinte à cette application. De même elle sera étudiée dans le cadre de mouvements cycliques où elle peut être facilement mise en oeuvre. Mais son adaptation à des mouvements qui ne se produisent qu'une fois peut cependant être aussi faite.

La représentation des objets en mouvement passe d'une manière classique par la saisie de clichés, clichés étant entendu au sens large, successifs régulièrement répartis dans le temps au cours du mouvement à étudier. La visualisation de ces clichés, à un rythme ralenti, permet de bien étudier le mouvement de l'objet. Les procédés de télévision modernes permettent, avec des caméras, de mettre en oeuvre cette technique dans la mesure où les caméras sont suffisamment rapides pour acquérir des images très proches les unes des autres dans le temps et dans la mesure où on visualise par la suite ces images en ralentissant le rythme de projection. Ces techniques générales malheureusement ne sont pas applicables facilement aux procédés d'imagerie par résonance magnétique nucléaire, ni de même d'ailleurs aux procédés de représentation des coupes tomodensitométriques obtenues avec des tomodensitomètres.

En effet, l'acquisition d'images de type tomographique avec de tels appareils n'est obtenue qu'après un traitement de reconstruction des images des coupes. Par exemple en RMN, les particules du corps d'un patient à étudier, situées dans la coupe, sont soumises à une séquence d'excitation au cours de l'expérimentation et restituent à l'issue un signal qui comporte une information représentative de leur nature. Malheureusement toutes les particules de la coupe réémettent un signal en même temps. Avec les procédés de reconstruction d'image connus on tourne la difficulté de cette réponse simultanée en réitérant un certain nombre de fois les expérimentations et en changeant, d'une expérimentation à une autre, les conditions d'acquisition du signal. Typiquement en imagerie par résonance magnétique nucléaire on effectue 256 expérimentations successives pendant une durée totale qui, au plus court, avoisine la demie minute. Dans le domaine des images tomodensitométriques la durée totale d'acquisition de l'ensemble des vues est de l'ordre de la seconde. Or dans un cas comme dans l'autre les cycles de fluctuation du corps humain, par exemple à l'endroit du coeur, sont du même ordre. Il en résulte que l'ensemble des séquences acquises, ou que l'ensemble des vues détectées, s'effectue pendant une durée voisine de celle de la pulsation cardiaque : à l'endroit du coeur les images sont brouillées.

Pour remédier à cet inconvénient de bougé on a, dans un premier temps, effectué une synchronisation. Cependant, en particulier en résonance magnétique nucléaire, les procédés d'excitation les plus rapides (dits SSFP Steady State Free Precession) qui correspondent une précession libre en régime d'équilibre des moments magnétiques des particules doivent être appliqués à un rythme propre. Ce rythme propre dépend du temps de relaxation spin-spin dit $T_2$ des moments magnétiques des particules étudiées. Ce rythme propre s'oppose bien entendu à la synchronisation. Il n'y a en effet aucune raison pour que ce rythme propre soit un multiple du rythme cardiaque. Si on synchronise (et donc si on abandonne l'idée du mode SSFP), et qu'en plus on veuille faire une image dite en $T_2$ (pour montrer les temps de relaxation spin-spin), il faut alors attendre entre chaque expérimentation une durée égale à trois ou quatre fois la durée $T_1$ (temps de relaxation spin-réseau) caractéristique des particules étudiées. Autrement dit chaque expérimentation dure de l'ordre de 2 secondes. L'acquisition des 256 séquences conduit alors à une durée, pour une seule image synchronisée pendant le cycle, d'environ 10 minutes compte tenu des pertes de temps lors des synchronisations. Or les médecins, pour pouvoir bien comprendre le fonctionnement du coeur, demandent de disposer d'environ 32 images pour un cycle cardiaque complet. Ceci conduit à une durée totale d'examen de 5 heures. Cette durée est tout à fait insupportable pour les patients. En outre, même si ces patients la supportaient, le cycle cardiaque n'est pas constant. De sorte que la synchronisation, effectuée par rapport à une date précise du cycle, des autres instants du cycle ne correspond pas toujours à un même état du coeur. L'avance ou le retard de phase par rapport à un état prédéterminé du coeur dépend de l'accélération ou du ralentissement du rythme cardiaque par rapport à un rythme cardiaque nominal estimé. Il en résulte que les images présentent des artefacts.

Dans un mode d'excitation en variante, dit $T_2$ rapide avec faible basculement, et en synchronisant, on peut aller beaucoup plus vite puisque typiquement un cycle en $T_2$ rapide dure environ 50 ms. De sorte qu'on peut acquérir 32 phases du cycle cardiaque sur une durée sensiblement égale à deux fois ce cycle. En imagerie avec résolution normale (256 séquences par phase), ceci conduit à une durée totale de l'expérimentation de 10 minutes. Mais l'imagerie $T_2$ rapide ne peut pas être menée systématiquement dans une même tranche : le signal de RMN s'y amortit trop, on perd en contraste. On utilise alors une technique multicoupe : pendant des temps morts en effectue des mesures dans d'autres coupes. Pratiquement l'expérimentation dure alors quatre fois plus longtemps : 40 minutes. C'est aussi bien trop long. De plus le même problème de synchronisation que ci-dessus se présente. Lorsque la fréquence cardiaque n'est pas constante (pendant 40 minutes !), les images présentent aussi des artefacts.

Une autre technique a été imaginée par Michael L. WOOD et R. Marc HENKELMAN du ONTARIO CANCER INSTITUTE AND DEPARTMENT OF MEDICAL BIOPHYSICS, UNIVERSITY OF TORONTO, TORONTO, CANADA. Elle a été publiée dans Medical Physics, Volume 13, numéro 6 de Novembre/Décembre. 1986. Elle consiste pour l'essentiel à effectuer une moyenne sur plusieurs images successives, en vue d'éliminer des artefacts de bougé. Cette technique d'imagerie, qui s'intéresse à l'élimination des effets des mouvements des parties mobiles, n'est bien entendu pas susceptible de restituer l'image mobile du mouvement que l'on cherche à rendre. Elle n'est de plus pas totalement efficace et certains parasites peuvent rester dans l'image.

La solution préconisée par l'invention est une solution générale qui permet, selon les besoins, de représenter les mouvements d'un objet mobile avec un ralenti aussi finement décomposé qu'on le désire, sans entraîner une multiplication correspondante des durées d'acquisition. En outre, dans les cas où les parties en mouvement sont considérées comme des perturbations, le procédé de l'invention permet de donner une image des parties fixes de l'objet exemptes des composantes relatives au mouvement. Pour l'essentiel, dans l'invention, on considère qu'un mouvement d'un objet s'analyse, dans une image, comme une variation temporelle de la luminosité des éléments d'image (on dit aussi pixels) de cette image. Et on avance que cette variation temporelle de luminosité d'un élément d'image peut être remplacée par un spectre de composantes fréquentielles (d'un signal élémentaire de base lorsque le mouvement étudié est cyclique). La décomposition spectrale est de préférence une décomposition dite de Fourier. Le signal temporel de variation de luminosité de chaque élément d'image est alors remplacé pour chaque élément d'image par la transformée de Fourier de cette luminosité.

Dans un cas simple, quand le phénomène étudié est cyclique, on peut considérer que les luminosités des éléments d'image comportent une composante continue, une composante fondamentale de variation cyclique, ainsi que des composantes harmoniques de variation cyclique. Le cycle étant supposé le même pour tout le corps étudié, la décomposition du mouvement du corps en série de Fourier permet, élément d'image par élément d'image, de disposer d'une série d'images représentatives chacune respectivement, de l'image fixe, de l'image de variation au rythme fondamental, et des images de variation au rythme des harmoniques du fondamental. On peut ensuite réobtenir l'image globale du mouvement en utilisant autant de générateurs d'images plus un que d'harmoniques d'image à prendre en compte. On combine, élément d'image par élément d'image, les participations de chacune des images harmoniques, et on visualise l'image ainsi combinée. Pour obtenir un ralenti aussi ralenti qu'on le désire il suffit de faire évoluer les générateurs d'image aussi lentement qu'on le désire. En définitive, on effectue ainsi une analyse harmonique de l'image. On remarque que l'image des parties mobiles seules peut aussi être obtenue en éliminant la composante continue d'image et que, par contre, l'image exempte d'artéfact de bougé peut être obtenue en utilisant que cette image de composante continue d'image seule.

L'invention a donc pour objet un procédé de prise en compte, dans une image, des mouvements d'un objet caractérisé en ce que :

— on détermine les composantes de la transformée analytique du mouvement,

— on élabore des images correspondant à chacune des composantes de la transformée analytique de ce mouvement,

— et on compose l'image de l'objet mobile en combinant les images des composantes.

L'invention sera mieux comprise à la lecture de la description qui suit et à l'examen des figures qui l'accompagnent. Celles-ci ne sont données qu'à titre indicatif et nullement limitatif de l'invention. Les figures montrent:

— Figure 1 : un dispositif d'imagerie par résonance magnétique nucléaire utilisable pour la mise en oeuvre du procédé selon l'invention ;

— Figures 2a à 2d : des diagrammes temporels de signaux de codage des expérimentations en vue de permettre la reconstruction des images ;

— Figure 3 : la modification d'un de ces signaux de codage pour mettre en oeuvre un exemple du procédé de l'invention ;

— Figure 4 : un dispositif utile à la composition de l'image combinée.

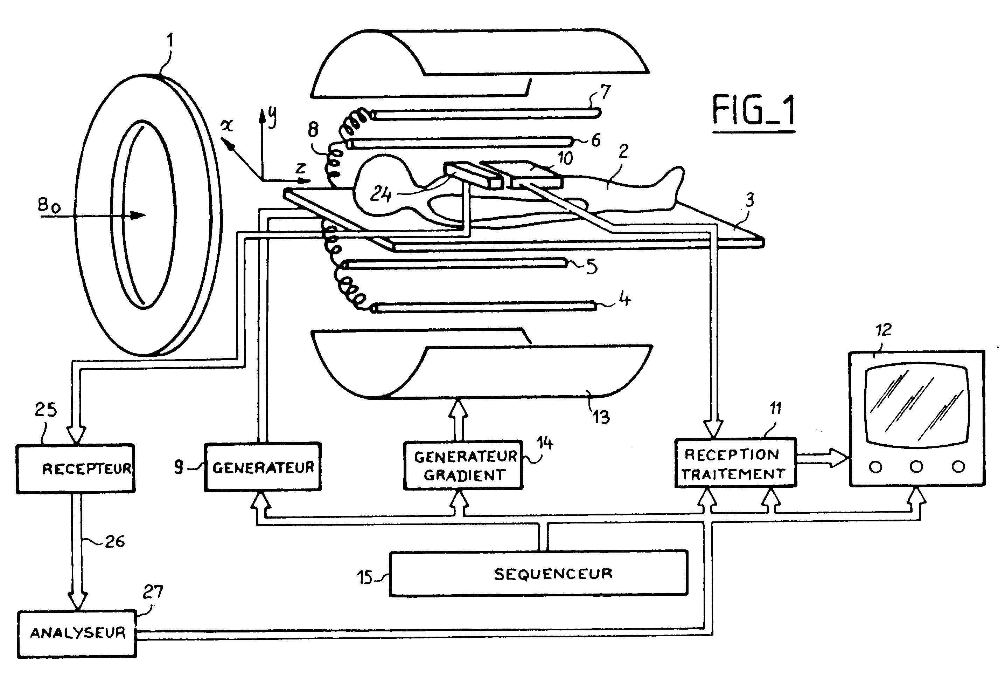

La figure 1 représente un dispositif d'imagerie par résonance magnétique nucléaire utilisé, dans un exemple, pour la mise en oeuvre du procédé de prise en compte selon l'invention. Cet appareil comporte essentiellement des moyens, symbolisés par une bobine 1, pour produire un champ magnétique uniforme intense $B_0$ dans une région où est placée le corps 2 d'un patient, au-dessus d'un plateau 3. Soumis à cette aimantation, les moments magnétiques des particules du corps 2 s'orientent selon la direction du champ uniform $B_0$. Dans cette situation on soumet en outre le corps 2 à une excitation électromagnétique radiofréquence transmise par une antenne, par exemple à barres rayonnantes 4 à 7, alimentée au travers d'un circuit résonnant 8 par un générateur d'excitation 9. A l'issue de l'excitation, une antenne de réception 10 permet de prélever le signal de déséxcitation qui marque le retour à l'équilibre des moments magnétiques des particules du corps 2. Ce signal est reçu et est traité dans un récepteur 11 en vue de la visualisation, sur un dispositif de visualisation 12, d'une image d'une coupe du corps 2.

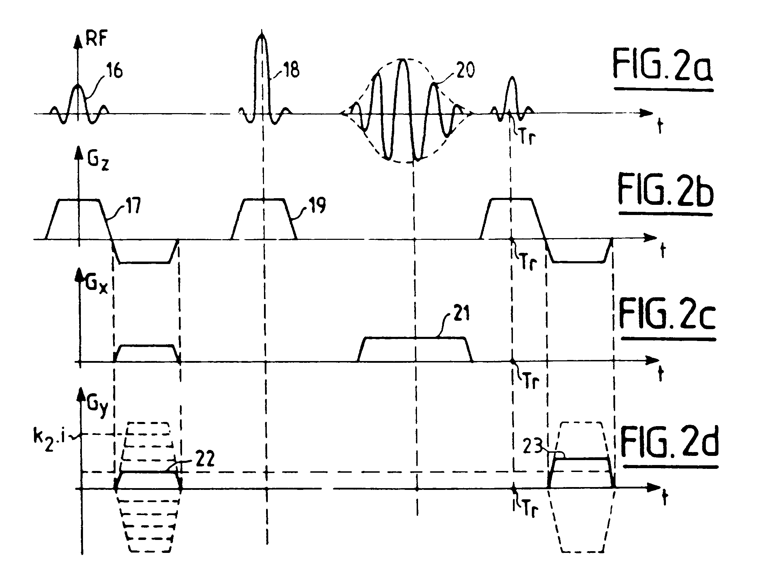

De manière à discriminer dans le signal reçu les contributions de chacun des éléments de volume de la coupe, une série d'expérimentations est entreprise au cours de chacune desquelles le codage magnétique de l'espace où est situé le corps 2 est fixé a une valeur différente par des champs magnétiques supplémentaires appliqués par des bobines dites de gradient représentées schématiquement en 13 et alimentées par un générateur d'impulsions de gradient 14. L'ensemble de ces moyens fonctionne sous la conduite d'un séquenceur 15. Dans la pratique on retiendra que l'image peut être reconstruite selon un procédé préféré de reconstruction dit 2DFT dont la figure 2 donne un aperçu des phases principales. Une excitation radiofréquence 16 est appliquée en présence d'une impulsion 17 de gradient de sélection de coupe. Une impulsion radiofréquence 18 dite d'écho de spin est émise ultérieurement en présence d'une impulsion 19 de gradient de sélection de coupe pour sélectionner la même coupe et pour éliminer des défauts d'homogénéité du champe $B_0$. Pendant la réception du signal 20 de désexcitation, une impulsion 21 d'un gradient dit de lecture est appliquée (axe X). Entre l'impulsion 16 et l'impulsion 18 un codage de phase 22 du signal de RMN est appliqué. D'une expérimentation à l'autre (au bout d'une durée Tr), ce codage de phase évolue : il atteint par exemple le niveau 23 pendant l'expérimentation suivante. Le calcul de reconstruction d'image est connu. Il comporte deux transformées de Fourier : une sur $k_1$ dependant du gradient de lecture et une sur $k_2$ dependant du gradient de codage de phase. Au cours d'une expérimentation de rang $\underline{i}$ le gradient de codage de phase vaut $k_2.i$.

Le corps 2 n'est bien entendu pas immobile pendant toutes ces expérimentations, en particulier à cause des pulsations cardiaques du patient. En conséquence les images acquises sont altérées par ces mouvements. Pour connaître l'influence de ces mouvements, dans l'invention, on cherche à connaître la transformée analytique du mouvement. Dans un premier temps, pour simplifier l'explication, cette transformée analytique peut être considérée comme étant la transformée de Fourier. L'analyse dépend en fait de l'espace des fonctions utilisées : içi les fonctions de Fourier. Dans ce but on dispose à proximité des parties en mouvement, en particulier ici près du coeur, un détecteur de mouvements cardiaques 24. Ce détecteur 24, du même type que ceux utilisés en synchronisation cardiaque classique, est relié à un récepteur 25 qui produit un signal 26 représentatif des mouvements de ce coeur. Le récepteur 25 est en relation avec un analyseur 27 susceptible de donner en sortie le cycle de base du mouvement. Du fait que le mouvement cardiaque est cyclique, l'analyse de ce mouvement se résume à la mesure de la durée de ce cycle. Les harmoniques d'image selon l'invention sont ensuite calculées selon une méthode décrite ci-dessous.

Considérons un moment magnétigue M (y, t) d'une particule dont l'amplitude est fonction du lieu $\underline{y}$ de la particule et du temps $\underline{t}$ de la manière suivante :

$$M\,(y,t) = a_0\,(y)\,e^{jA\,\sin\,wt} \qquad I$$

Dans cette expression, $a_0$ indique l'amplitude de la valeur de ce moment magnétique en fonction du temps, j est tel que $j^2 = -1$, et $\underline{w}$ représente la pulsation d'un signal sinusoïdal (ici il s'agit donc d'un signal sinusoïdal pur). L'expression de $\overline{M}$ peut encore s'écrire :

$$M(y,t) = a_0(y) + a_0(y)\,j\,\frac{A}{2}e^{jwt} - a_0(y)j\frac{A}{2}\,e^{-jwt}$$

ou encore en première approximation

$$M(y,t) = a_0(y) + a_1(y)\,e^{jwt} + a_{-1}(y)\,e^{-jwt}$$

où $a_1(y)$ et $a_{-1}(y)$ sont ainsi les coefficients de la décomposition en série de Fourier de la valeur de M(y, t). Cette décomposition en série de Fourier est relative au fait qu'ici, pour simplifier, le mouvement est supposé sinusoîdal pur.

Au cours d'une excitation de RMN, les moments magnétiques des particules situées à une ordonnée $\underline{y}$ ne contribuent pas seuls au signal de RMN reçu par l'antenne 10. Ils y contribuent en commun avec ceux des particles voisines situées à une même abscisse $\underline{x}$ mais à une autre ordonnée $\underline{y}$, ainsi qu'avec ceux situées à d'autres abscisses $\underline{x}$ et même à d'autres altitudes $\underline{z}$ (voir les axes de référence sur la figure 1). Si on suppose que les codages provoqués au cours des séquences par le générateur 14 d'impulsions de gradient ont eu pour effet de cantonner la naissance d'un signal de RMN utilisable à une tranche prédéterminée du corps 2 (on fait une image à deux dimensions avec une sélection de coupe), et si un gradient de lecture 21 a été appliqué au moment de la détection du signal par l'antenne 10, on peut, après filtrage fréquentiel ou après calcul d'une transformé de Fourier, extraire du signal reçu un signal qui peut s'écrire de la manière suivante :

$$s(x,1.tr) = \int_Y e^{j.k_2.1.y} M(y,1.Tr)\, dy$$

Cette expression signifie que le signal détecté est prélevé au cours d'une séquence d'excitation-mesure de rang i. Comme les séquences ont chacune une durée Tr, le signal est donc détecté à la date i.Tr. Le signal de RMN à cet instant est alors l'intégrale (sur dy) du moment magnétique de toutes les particules se trouvant le long de Y. Pour chaque particule se trouvant dans un élément de volume d'ordonnée $\underline{y}$, une fois qu'a été codé le signal de résonance par un gradient de codage de phase d'amplitude $k_2.i$ (puisqu'il est appliqué au cours de la séquence de rang i), la phase relative vaut $k_2 i.y$. Dans cette expression on peut remplacer M par sa valeur fonction de $a_0$, $a_1$, et $a_{-1}$. Si de plus on considère, dans un cas particulier qu'ultérieurement on généralisera, qu'un signal de RMN a été émis en $y_0$ seulement, le signal $\underline{s}$ devient (en négligeant maintenant l'influence de $\underline{x}$ qui de ce point de vue ne modifie pas le sens des expressions) :

$$s(1.Tr) = a_0(y0)\, e^{jk_2.1.y_0} + \; a_1(y_0)e^{jk_2.1(y_0 - wTr/k_2)} + \; a_{-1}\cdots$$

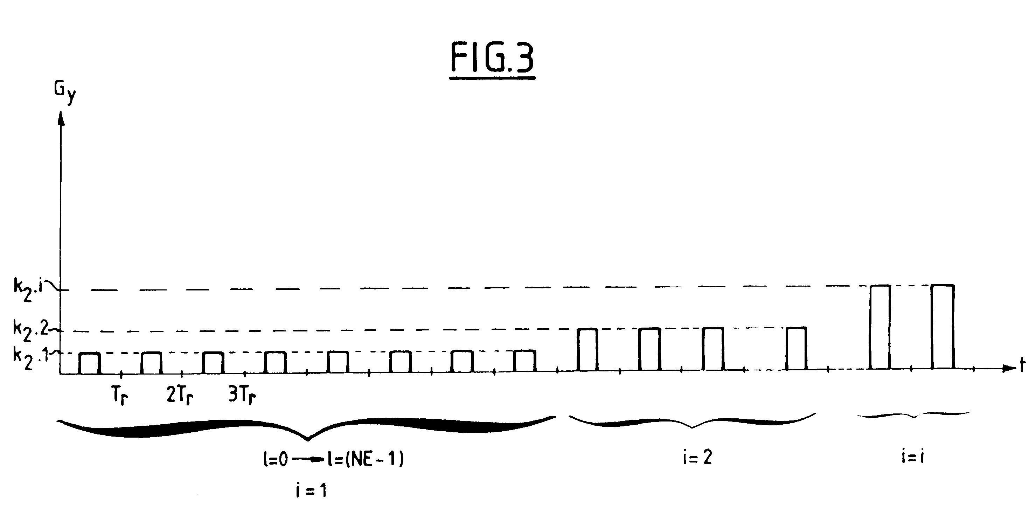

On peut alors considérer que la première partie (en $a_0$) du deuxième membre de l'égalité concerne la contribution des particules fixes à l'endroit de l'élément de volume $y_0$, tandis que ce qui suit (en $a_1$ et $a_{-1}$) concerne les particules mobiles dans l'élément de volume $y_0$. Supposons maintenant qu'avec la même valeur de $k_2.i$ on effectue un nombre NE d'expérimentations successives identiques. En définitive au lieu d'acquérir une série de 2N séquences (i allant de $-N$ à $N-1$ ; dans un exemple type où $2N = 256$, i va de $-128$ à $+127$) on peut acquérir NE (par exemple NE = 8 pour fixer les idées) séquences identiques pour chaque valeur de i. On acquiert donc NE $\times$ 2N séquences au total (voir Fig. 3). Les NE séquences sont identiques à cela près que les instants d'acquisition ne sont pas les mêmes, et sont bien entendu décalés dans le temps. Supposons, en outre, qu'au lieu d'un signal sinusoïdal pur on ait affaire en fait à un signal périodique de pulsation fondamental $\underline{w}$ mais possédant en plus certains harmoniques. Si on appelle p(t) le signal représentant la phase de la pulsation fondamentale de variation du signal périodique, on peut écrire :

$$
\begin{aligned}
M(y_0,1) = {} & a_0(y_0) + a_1(y_0)\, e^{jp(1)} + a_{-1}(y_0)\, e^{-jp(1)} \\
& + a_2(y_0)\, e^{j2p(1)} + a_{-2}(y_0)\, e^{-j2p(1)} \qquad \text{II} \\
& + a_3(y_0)\, e^{j3p(1)} + a_{-3}(y_0)\, e^{-j3p(1)} \\
& + \; \cdots
\end{aligned}
$$

Dans cette expression l désigne le rang d'une des expérimentations prises parmi les NE retenues. Il indique en fait la date l. Tr à laquelle est mesuré le signal de RMN. Dans la pratique $\underline{l}$ vaut de 0 à NE-1. Cette dernière expression contient en substance toutes l'essence de l'invention M ($y_0$, l) représente la luminosité à afficher d'un point d'ordonnée $y_0$ à une date l. La valeur $a_0(y_0)$ représente la composante continue de luminosité à cet endroit de l'image : elle est indépendante du temps puisqu'elle est une composante continue. Les termes en $a_1$ et $a_{-1}$ représentent, en fonction du fondamental p(l) et du temps l, l'influence des coefficients pondérateurs de ce fondamental à l'endroit de l'ordonnée $y_0$. Les termes en $a_2$ et $a_{-2}$ représentent les mêmes influences pour l'harmonique 2 (2p(l)), et ainsi de suite. Autrement dit, pour un lieu $y_0$, connaître la valeur du moment magnétique M (ou ce qui est équivalent la luminosité d'un point correspondant sur l'image) revient à déterminer les coefficients $a_0$ et a n et $a_{-n}$, jusqu'à n aussi grand qu'on le désire, de manière à bien représenter le mouvement. On sait que la décomposition en série de Fourier permet, pour représenter la modulation du signal de départ, de se satisfaire d'un nombre restreint d'harmoniques : ceux dont les coefficients $a_n$ ont encore une valeur significative. Dans l'explication qui va suivre on se limitera à n = 3 bien que cela ne constitue pas une obligation. Il y a lieu cependant de se rappeler l'application du théorème de Shannon selon lequel la connaissance d'un signal à une fréquence nw n'est atteinte que si pendant une durée 1/nw le nombre d'échantillons pris en compte est supérieure à 2. On peut montrer que dans le cas présent, où on a choisi NE = 8, la connaissance du troisième harmonique est donc totalement envisageable (8 est plus grand que $2 \times 3 + 1$).

Si l'on effectue, ainsi qu'on l'a prévu, les NE = 8 mesures, on est alors confronté à la situation selon laquelle on dispose de 8 valeurs du signal s(l.Tr) alors qu'on ne cherche en fait que 7 inconnues qui sont $a_0$, $a_1$, $a_{-1}$,...$a_{-3}$. La solution de ce système d'équations, peut être apportée par une méthode d'approximation, sur le plan pratique par une méthode d'approximation par des moindres carrés.

Dans un cas particulièrement simple, où les NE mesures sont effectuées pendant une durée exactement égale à la période fondamentale du phénomène cyclique examiné, et dans lequel la pulsation du fondamental est constante dans le temps, on peut arriver après calcul à la solution simple suivante :

$$a_0 = 1/8 \sum_{l=0}^{l=7} s.(l.Tr)$$

$$a_1 = 1/8 \sum_{l=0}^{l=7} e^{-j \frac{2\pi}{8} .l.1} .s(l.Tr)$$

$$\cdots\cdots\cdots$$

$$a_{-3} = 1/8 \sum_{l=0}^{l=7} e^{j \frac{2\pi}{8} .l.3} .s(l.Tr)$$

Les deux dernières expressions nous permettent de montrer qu'en fait $a_h$ est le coefficient pondérateur de la composante de Fourier de rang h de la décomposition en série de Fourier du phénomène cyclique en question. Mais dans ce cas où la fréquence n'est pas constante, ou bien dans le cas où les NE mesures ne sont pas reparties exactement sur une cycle du mouvement, les fonctions $e^{jp(l)}$ ne sont plus orthogonales. Il faut généraliser le traitement du calcul des $a_h$ sous forme, par exemple, d'un calcul des moindres carrés. Ce calcul est rendu nécessaire du fait que, dans ces cas, la décomposition de la fonction temporelle d'aimantation n'est plus effectuée sur une base de fonctions analytiques orthogonales. Autrement dit la base des fonctions analytiques choisies n'a pas besoin d'être orthogonale sous reserve qu'une approximation des $a_h$ soit entreprise. La dernière formulation II de M($y_0$,l) conduit, en assimilant M à s dans la mesure où seul un élément de volume d'ordonnée $y_0$ du corps 2 émet une réponse à l'issue des expérimentations, à la formulation matricielle suivante:

$$\begin{vmatrix} 1 & e^{jp(0)} & e^{2jp(0)} & \cdots\cdots\cdots\cdots\cdots & e^{-3jp(0)} \\ 1 & e^{jp(1)} & e^{2jp(1)} & \cdots\cdots\cdots\cdots\cdots & \\ & \cdots\cdots\cdots\cdots\cdots\cdots\cdots & & & \\ 1 & e^{jp(l)} & \cdots\cdots\cdots\cdots\cdots\cdots & & \\ 1 & e^{jp(7)} & \cdots\cdots\cdots\cdots\cdots\cdots & e^{-3jp(7)} \end{vmatrix} \bullet \begin{vmatrix} a_0 \\ a_1 \\ a_2 \\ \cdots \\ a_{-3} \end{vmatrix} = \begin{vmatrix} s(0) \\ s(1) \\ \cdots \\ s(l) \\ s(7) \end{vmatrix}$$

Dans cette equation le signe = a un sens qui doit donc être interpreté dans le sens d'un calcul par des moindres carrés. Cette équation peut encore s'écrire

$$|P| \cdot |"a"| = |S|$$

Cette formulation matricielle rend compte des valeurs des différents signaux s(l.Tr) en fonction des harmoniques (np(l)) du mouvement considéré. En définitive ce qui est inconnu est le vecteur "a", tandis que ce qui est connu est le vecteur S ainsi que la matrice P. La matrice P est connue puisque on connaît le cycle fondamental 1.p(l), les harmoniques h.p (l), et puisqu'on connaît également les instants l.Tr auxquels sont pris les échantillons. La théorie du calcul matriciel permet d'écrire pour mettre en oeuvre le calcul par les moindres carrés :

$$|"a"| = [|P^*| \cdot |P|]^{-1} \cdot |P^*| \cdot |S|$$

Dans cette expression P* représente la matrice conjuguée de la matrice P, telle que chaque élément $q_{ij}$ de P* est tel que $q_{ij} = p_{ji}^*$ si $P_{ji}$ est un élément de P. L'exposant −1 correspond à une inversion de matrice dont la définition est telle que $P \cdot P^{-1} = I$ où I est la matrice identité. Avec cette dernière méthode on peut donc calculer le vecteur "a".Ce calcul est le calcul des moindres carrés.

Il importe maintenant de généraliser l'explication au cas où il n'y a pas seulement un point $y_0$ qui émet un signal utile. En effet dans un expérimentation d'imagerie par résonance magnétique nucléaire, dans une coupe au moment de la lecture, toutes les particules situées sur une même colonne (donc d'ordonnée $\underline{y}$ différente et de même abscisse $\underline{x}$) contribuent au signal. On peut écrire, en supposant que les $a_n$ sont connus, qu'en un endroit d'ordonnée $\underline{y}$ et à une date $\underline{l}$ ; le moment magnétique correspondant a une amplitude de la forme :

$$M\,(y,l) = \sum_{h=-n}^{h=+n} a_h\,(y).e^{\,j.h.p(l)} \qquad\qquad III$$

déjà vue précédemment mais généralisée ici à toutes les coordonnées et à toutes les harmoniques.

Comme tous les signaux situés à une même abcisse $\underline{x}$ et d'ordonnée $\underline{y}$ participent en même temps au signal reçu, on peut écrire :

$$s(l) = \int_Y e^{\,j\,k.2^{i}.y} \left( \sum_{h=-n}^{h=+n} a_h\,(y)\,e^{\,jhp(l)} \right) dy$$

qui est une expression intégrale de laquelle on peut sortir l'expression suivante :

$$s(I) = \sum_{h=-n}^{h=+n} \left( \int_Y e^{jk_2 i \cdot y} \cdot a_h(y)\, dy \right) e^{jhp(I)}$$

Dans cette dernière expression, on peut admettre que l'intégrale puisse s'écrire sous la forme $A_h^i$. Cette formulation en fait repose sur un certain nombre de suppositions. Premièrement il est supposé que, pendant les NE $\times$ 2N mesures effectuées les coefficients $a_h$ sont constants. Ceci signifie en définitive que le phénomène est stationnaire (mais pas que son cycle est de durée constante). Si son rythme n'est pas constant, par contre sa forme du mouvement doit pouvoir se déduire, d'un cycle à l'autre, par compression ou dilatation temporelle uniquement. Dans cette expression i représente le codage $i.k_2$ tandis que $\underline{h}$ dépend de l'harmonique considéré. Le vecteur précédent "a", à sept composantes pour trois harmoniques, devient maintenant une matrice généralisée appelée A, à (2n + 1).2N dimensions. Dans l'exemple, elle a 7 $\times$ 256 dimensions. Le chiffre 256 représente la résolution désirée de l'image ainsi que le nombre désiré de différentes valeurs de $k_2.i$. Cette matrice peut s'écrire :

$$A = \begin{vmatrix} A_0^0 & A_0^1 & \cdots\cdots\cdots\cdots\cdots & A_0^{256} \\ A_1^0 & A_1^1 & \cdots\cdots\cdots\cdots\cdots & A_1^{256} \\ A_{-1}^0 & A_{-1}^1 & \cdots\cdots\cdots\cdots\cdots & A_{-1}^{256} \\ & \cdots\cdots\cdots\cdots\cdots\cdots\cdots\cdots & \\ & \cdots\cdots\cdots\cdots\cdots\cdots\cdots\cdots & \\ A_{-3}^0 & A_{-3}^1 & \cdots\cdots\cdots\cdots\cdots & A_{-3}^{256} \end{vmatrix}$$

La matrice A correspond pour toutes les séquences i, aux contributions de toutes les particules d'une même colonne à l'image fixe ($A_0$), aux images du fondamental ($A_1$, $A_{-1}$), ou aux images des harmoniques ($A_n$, $A_{-n}$). Pour chaque séquence, pour chaque valeur de $i.k_2$, compte tenu du fait qu'on a acquis $\underline{I}$ signaux, il est possible de calculer les coefficients $A_h^i$ par moindres carrés. Autrement dit, à chaque série de NE mesures pour une valeur $i.k_2$ déterminé, il est possible de connaître les coefficients $A_h^i$ en question. Mais ce qui nous intéresse est en fait la connaissance des coefficients $a_h(y)$. Il importe donc d'effectuer des transformées de Fourier, en utilisant le fait qu'on dispose de multiples expérimentations $i.k_2$ (et dans ce cas on dit qu'on fait une transformée de Fourier "sur $k_2$") pour retrouver les coefficients $a_h(y)$. Ces transformées de Fourier sur $k_2$ sont identiques à celle pratiquée dans un procédé de reconstruction d'image du type 2DFT classique. La seule particularité de l'invention réside dans le fait que ces dernières transformées de Fourier sont effectuées, ici, 2n + 1 fois étant donné qu'on cherche à connaître, pour chaque élément d'image de l'image, non pas une seule valeur de luminosité, mais les 2n + 1 valeurs $a_0$, $a_1$, $a_{-1}$,... $a_{-n}$ des harmoniques d'image.

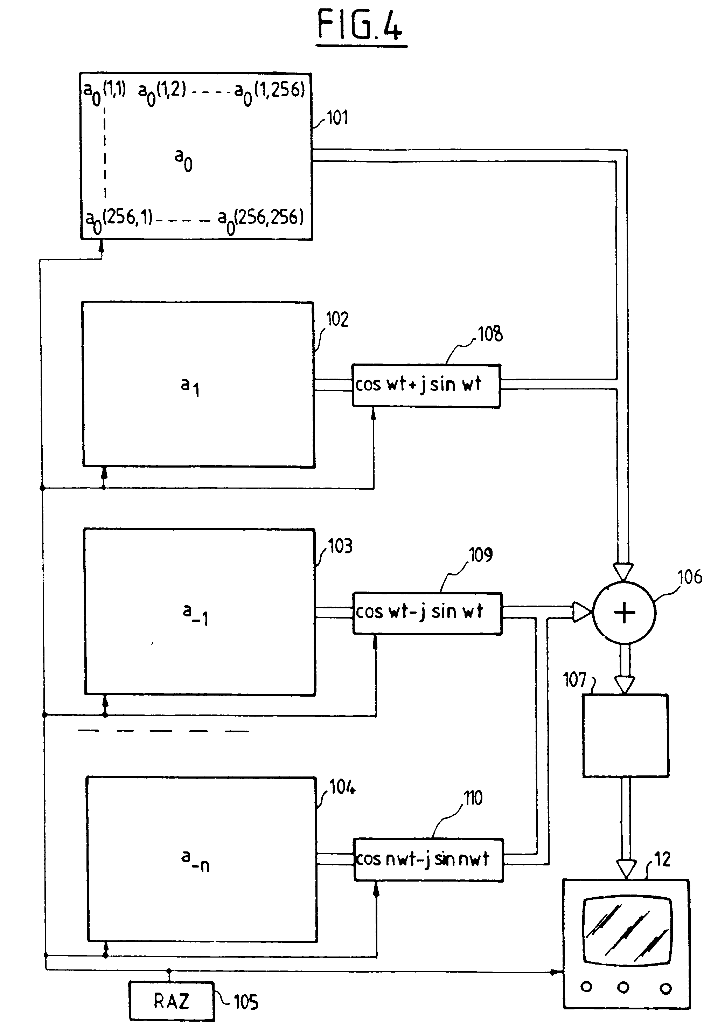

La figure 4 montre comment, ultérieurement, est recombinée l'image des éléments mobiles. On dispose en pratique de 2n + 1 mémoires d'image numérotées 101 à 104. Ces mémoires d'image sont destinées à entre lues simultanément sous la commande d'un dispositif de remise à zéro 105. Leurs contenus sont additionnées, élément d'image, par élément d'image, dans un additionneur 106 en vue d'alimenter une autre mémoire d'image 107 qui, elle, peut être lue par le dispositif de visualisation 12. Dans l'invention on multiplie les valeurs, élément d'image par élément d'image, des mémoires d'images par une fonction cos h wt + j sin h.wt avant l'addition. Es multiplicateurs 108 à 110 sont ainsi montrés à cet effet. La valeur $\underline{t}$ n'est pas nécessairement prise au rythme où elle évolue en temps réel. Dans le cas où on veut un ralenti très finement représenté on fait évoluer très lentement la valeur t tout en lisant la mémoire d'image 107 à un rythme compatible avec une lecture vidéo classique (25 images par seconde). En résumé dans l'exemple décrit on n'a acquis que huit fois plus d'informations (NE = 8) et on peut avoir un ralenti aussi finement représenté qu'on le désire (en faisant faiblement varier la valeur de t). Mais l'invention apporte en plus un autre avantage. Si on considère que tout ce qui bouge n'est pas intéressant, on peut l'éliminer en ne prenant en compte que les coefficients de la matrice $a_0$ contenus dans la mémoire d'image 101. De cette manière on élimine simplement les artéfacts de bougé.

Il reste maintenant à traiter plusieurs problèmes. Le premier concerne la variation du cycle de base w du mouvement étudié au cours de toutes les mesures. En effet si la durée de celle-ci dure de l'ordre de cinq minutes, le rythme cardiaque ne peut pas être considéré comme constant pendant une telle durée. Cependant, avec le détecteur 16, le récepteur 17, et l'analyseur 18, il est possible de connaître non seulement le cycle cardiaque mais même les variations de ce cycle. On peut admettre dans un premier temps que les variations de ce cycle seront faibles de sorte que le nombre d'échantillons à prendre en compte, eu égard au nombre d'harmoniques qu'on cherche à représenter, respectera toujours les contraintes opposées par Shannon. Si tel n'est pas le cas il suffit tout simplement d'augmenter d'une quantité nécessaire le nombre des échantillons.

On se retrouve alors dans la situation suivante : les instants l, où les mesures sont effectuées, sont connus dans l'absolu puisqu'ils sont imposés par le séquenceur. Mais leur position relative par rapport au cycle fondamental évolue. Cela a seulement pour effet de compliquer légèrement le calcul des $e^{jhp(l)}$ puisque, dans ces conditions, la matrice P varie d'une séquence à l'autre. La phase p (l) peut peut s'écrire

$$p(l) = \int_0^{l.Tr} w(t)^{\cdot} dt$$

Dans l'analyseur 27 en fait on ne mesure pas la forme du mouvement si ce mouvement est cylique : on se contente de mesurer le temps d'apparition d'un événement caractéristique du cycle mesuré. Par définition la phase de la pulsation fondamentale lors de l'apparition de cet évenement est $2\pi$ (en fait $k.2\pi$). On suppose, mais cela peut être généralisé, que la contraction ou la dilatation du cycle est homogène entre deux évenements successifs. Dans ce cas la phase d'une mesure de rang l, comprise entre les événements k et k + 1, est alors p(l) = (l.Tr − T(k)/(T(k + 1) − T(k)). Si la variation du cycle n'est pas homogène il suffit de faire une interpolation non linéaire entre T(k) et T(k + 1). Pour l'examen du coeur on préfère une telle interpolation non linféaire car, en cas d'accélération du rythme, la diastole s'accélère relativement plus que la systole. Ainsi, dans ce cas particulier, la détermination des composants de la transformée analytique (de Fourier) du mouvement se résume à la mesure de l'arrivée d'un évenement caractéristique et à la mesure de la phase relative par interpolation (linéaire ou non).

On peut aussi étudier le cas où le mouvement n'est pas seulement créé par un seul mouvement périodique mais par deux mouvements périodiques imbriqués. Dans la pratique on pense ainsi à la simultanéité de la pulsation cardiaque et du rythme respiratoire. Il n'y a aucune raison pour que l'un soit le multiple de l'autre. En pratique tout ce qui a été dit jusqu'à présent peut être généralisé puisque la combinaison de deux mouvements peut s'analyser comme une modulation par multiplication d'un mouvement par l'autre. Le spectre de la décomposition en série de Fourier qu'il y a lieu de prendre en compte est alors équivalent au spectre de la pulsation la moins rapide déplacée des valeurs du fondamental et des harmoniques du spectre de la pulsation la plus rapide.

Sur la figure 3 on a représenté des séries d'expérimentations avec des mêmes valeurs de $k_2.i$ qui se suivent consécutivement. Il est cependant possible d'interlacer des valeurs de $k_2.i$ égales avec d'autres valeurs de $k_2.i$. Cette hypothèse se justifie d'autant plus que le procédé de l'invention est compatible avec un mode d'excitation SSFP dont le rythme propre peut être très faible (bientôt quelques millisecondes). Dans un cycle cardiaque d'une seconde il devient alors possible d'effectuer plusieurs trains de sequences à des valeurs $i.k_2$ différentes mais interlacées entre elles : par exemple un train comportant des suites, une séquence $i.k_2$ — une séquence $(i + 1). k_2$, suivi d'un train comportant des suites une séquence $(i + 2). k_2$ — une séquence $(i + 3).k_2$, etc...

La décomposition en série de Fourier du mouvement est par ailleurs uniquement justifiée dans la mesure où, dans les multiplicateurs 108 à 110, on utilise, ce qui paraît le plus simple, des fonctions sinusoïdales. On peut cependant envisager de décomposer le mouvement selon d'autres fonctions analytiques dont l'intérêt pourrait se justifier pour telle on telle raison. Pour cette raison, dans la revendication principale il est évoqué une transformée analytique, cette transformée analytique étant une transformée de Fourier, lorsque que l'analyse du mouvement est une analyse de Fourier.

En résumé, dans le cadre d'une application d'imagerie par RMN le procédé de l'invention comporte les phases suivantes. Pour chaque expérimentation on excite le corps, on code magnétiquement l'espace, et on entreprend la lecture du signal réémis par les particules. La présence d'un gradient de lecture pendant cette lecture permet, en effectuant une transformée de Fourier sur l'axe de lecture (en général l'axe x) de disposer, pour NE mesures avec un gradient de codage de phase $i.k_2$, et pour toutes les valeurs possibles de ce gradient codeur de phase, d'un ensemble de valeurs de signaux détectés fonction de leur date d'acquisition (l) et du codage qu'ils ont subi ($i.k_2$). Pendant la mesure des signaux réémis, on effectue également une mesure du rythme du mouvement des parties en mouvement (par exemple du rythme cardiaque). On détermine alors par rapport à ce rythme mesuré, des évolutions p (l) utiles en tenant compte, en particulier, des variations possibles de ce rythme au cours de l'ensemble des mesures. On dispose donc de la matrice P utilisable pour chaque série de NE séquences. On calcule alors $|P^* \cdot P|^{-1} \cdot P^*$ pour une valeur de $i.k_2$, c'est-à-dire pour NE valeurs de signal mesurées. On calcule ainsi les $A_h^i$ relatifs à la séquence $i.k_2$, dans un exemple pour h appartenant à $-3, +3$. Et on réitère ce calcul autant de fois qu'il y a de valeurs $i.k_2$ différentes.

Ensuite, en disposant de l'ensemble des valeurs $A_h^i$ on calcule par $2n + 1$ transformées de Fourier sur $k_2$ l'ensemble des valeurs $a_h$ (y) affecté à chacune des ordonnées y des points d'une colonne d'abcisse $\underline{x}$. On effectue le même travail pour toutes les abcisses $\underline{x}$ du plan, et on dispose ensuite des mémoires d'images représentées sur la figure 4. La recombinaison de l'image s'effectue ensuite en fonction de ce que l'on cherche à montrer. Comme l'élaboration des images est faite par calcul en nombres complexes (j) on peut décider, d'une manière connue, de montrer l'image réelle, l'image imaginaire, ou même l'image en module. On peut même si les besoins de la visualisation le requièrent moduler par un coefficient de contraste certaines des images, fixes ou mobiles, de façon à souligner ou à effacer certaines parties de l'image recombinée.

## Revendications

1. Procédé de prise en compte des mouvements d'un objet dans le but d'obtenir une image de cet objet caractérisé en ce que :
— on détermine les composantes de la transformée analytique de ces mouvements,
— on élabore des images correspondant à chacune de ces composantes de la transformée analytique de ces mouvements,
— et on compose l'image de l'objet en combinant les images des composantes.

2. Procédé selon la revendication 1, caractérisé en ce que l'analyse est une analyse de Fourier, les transformées analytiques étant des transformées de Fourier.

3. Procédé selon la revendication 2, caractérisé en ce que pour élaborer les composantes de la transformée de Fourier on décompose les mouvements en série de Fourier.

4. Procédé selon la revendication 3, caractérisé en ce que pour décomposer on mesure la période d'un mouvement cyclique de base de l'objet.

5. Procédé selon l'une quelconque des revendications 1 à 3, caractérisé en ce que pour décomposer on combine certaines ou même une seule, des images correspondantes.

6. Procédé selon l'une quelconque des revendications 1 à 5, caractérisé en ce que pour combiner les images des composantes on les affecte de coefficients de contraste.

7. Utilisation du procédé selon l'une quelconque des revendications 1 à 6 dans un procédé d'imagerie par résonance magnétique nucléaire.

## Patentansprüche

1. Verfahren zum Berücksichtigen von Bewegungen eines Gegenstandes, um ein Bild dieses Gegenstandes zu gewinnen, dadurch gekennzeichnet, daß :
— die Komponenten der analytischen Transformierten dieser Bewegungen bestimmt werden,
— die Bilder, die jeder dieser Komponenten der analytischen Transformierten dieser Bewegungen entsprechen, entwikkelt werden,
— und das Bild des Gegenstandes durch die Kombination der Bilder der Komponenten aufgebaut wird.

2. Verfahren gemäß Anspruch 1, dadurch gekennzeichnet, daß die Analyse eine Fourier-Analyse ist, wobei die analytischen Transformierten die Fourier-Transformierten sind.

3. Verfahren gemäß Anspruch 2, dadurch gekennzeichnet, daß zur Entwicklung der Komponenten der Fourier-Transformierten die Bewegungen in eine Fourier-Reihe zerlegt werden.

4. Verfahren gemäß Anspruch 3, dadurch gekennzeichnet, daß zur Zerlegung die Periode einer zyklischen Bewegung der Basis des Gegenstandes gemessen wird.

5. Verfahren gemäß einem der Ansprüche 1 bis 3, dadurch gekennzeichnet, daß zur Zerlegung bestimmte oder selbst ein einziges der entsprechenden Bilder kombiniert werden bzw. wird.

6. Verfahren gemäß einem der Ansprüche 1 bis 5, dadurch gekennzeichnet, daß zur Kombination der Bilder der Komponenten diesen Kontrastkoeffizienten zugeordnet werden.

7. Anwendung des Verfahrens gemäß einem der Ansprüche 1 bis 6 in einem Kernspinresonanz-Abbildungsverfahren.

## Claims

1. A method for taking into account the movements of an object with the purpose of producing an image of the object, characterized by :
— ascertaining the components of the analytical transform of the movements,
— processing the images corresponding to each of the said components of the analytical transform of the movements, and
— composing the image of the object combination of the images of the components.

2. The method as claimed in claim 1, characterized in that the analysis is a Fourier analyse, the analytical transforms being Fourier transforms.

3. The method as claimed in claim 2, characterized in that in order to process the components of the Fourier transform the movements are broken down into a Fourier series.

4. The method as claimed in claim 3, characterized in that in order to break down the movements the period of the cyclical movement of the base of the object is measured.

5. The method as claimed in any one of the preceding claims 1 through 3, characterized in that in order to break down the movements certain corresponding images or only one thereof are combined.

6. The method as claimed in any one of the preceding claims 1 through 5, characterized in that in order to combine the images of the components the same are affected by contrast coefficient.

7. The use of the method as claimed in any one of the preceding claims 1 through 6 in an imaging method employing nuclear magnetic resonance.

FIG_1

FIG.2a

FIG.2b

FIG.2c

FIG.2d

# FIG.3

EP 0 297 935 B1

# FIG.4

$a_0(1,1) \quad a_0(1,2) ---- a_0(1,256)$

101

$a_0$

$a_0(256,1) --- a_0(256,256)$

102

$a_1$

108

$\cos wt + j \sin wt$

103

$a_{-1}$

109

$\cos wt - j \sin wt$

106

+

107

104

$a_{-n}$

110

$\cos nwt - j \sin nwt$

12

RAZ — 105